Europäisches Patentamt

European Patent Office

Office européen des brevets

(19)

(11) **EP 0 773 448 A1**

(12) **EUROPEAN PATENT APPLICATION**

(43) Date of publication:
**14.05.1997 Bulletin 1997/20**

(51) Int Cl.$^6$: **G01R 31/28**, G06F 11/24

(21) Application number: **96630062.6**

(22) Date of filing: **08.11.1996**

(84) Designated Contracting States:
**DE GB**

(30) Priority: **09.11.1995 US 555391**

(71) Applicant: **SUN MICROSYSTEMS INC.**
**Mountain View, California 94043-1100 (US)**

(72) Inventor: **Fowler, Boyd**
**Sunnyvale, California 94086 (US)**

(74) Representative: **Schmitz, Jean-Marie et al**
**Dennemeyer & Associates S.A.,**
**P.O. Box 1502**
**1015 Luxembourg (LU)**

(54) **Leakage current control system for low voltage CMOS circuits**

(57)    A leakage current control circuit for controlling leakage current within a semiconductor region includes a current source, a biasing circuit and a test device integrated within the semiconductor region. Where the semiconductor region is P-type, such as a P-type integrated circuit substrate, the test device is an N-MOS transistor, and where the semiconductor region is N-type, such as an N-well within a P-type integrated circuit substrate, the test device is a P-MOS transistor. The MOS transistor has its gate and source terminals shorted together so that any current flowing through it will be leakage current only. The current source provides an input signal to the MOS transistor and biasing circuit. The biasing circuit compares the input signal to a reference signal to which the desired leakage current corresponds and, based upon such comparison, applies a bias signal to the semiconductor region which is also the bulk terminal for the MOS transistor. Based upon such applied bias signal, the leakage current flowing through the MOS transistor can be selected in accordance with the reference signal applied to the biasing circuit.

FIG. 2

**Description**

BACKGROUND OF THE INVENTION

1. Field of the Invention

The present invention relates to low voltage complementary metal oxide semiconductor (CMOS) circuitry, and in particular, to control circuits for regulating leakage currents within CMOS circuitry.

2. Description of the Related Art

As CMOS circuit technology has advanced, the sizes and dimensions of the individual CMOS devices have decreased further and further. Accordingly, power supply voltages and device threshold voltages have decreased, as well. As a result, device performance has become increasingly sensitive to temperature and fabrication process variations and, perhaps more importantly, leakage currents have become proportionately more significant. Such increases in leakage currents, relative to the device threshold voltages and normal operating currents, are undesirable for at least two reasons. First, such leakage currents represent increasing proportions of the overall power supply current needed while contributing nothing to overall circuit performance. Second, as such leakage currents represent greater proportions of the overall current used by a circuit during normal operation, the chances for interference by such currents with normal device operation become more significant.

Accordingly, it would be desirable to have some means by which leakage currents within low voltage CMOS circuitry can be controlled and selectively reduced.

SUMMARY OF THE INVENTION

An apparatus including a leakage current control circuit in accordance with the present invention advantageously allows the user of an integrated circuit to select and control the amount of leakage current conducted within a C-MOSFET integrated circuit and to allow such control to be exercised independently for both P-MOS and N-MOS devices. Further, such control remains consistent over wide ranges of temperature and leakage currents, as well as variations in device fabrication processes.

An apparatus including a leakage current control circuit in accordance with one embodiment of the present invention includes: a semiconductor region; a signal node for conducting an input signal; a semiconductor device which is integrated within the semiconductor region and coupled to the signal node for conducting a leakage current; and a bias circuit, coupled to the signal node and the semiconductor region, for receiving a portion of the input signal and in response thereto providing a bias signal to the semiconductor region, wherein the semiconductor device receives and selectively conducts another portion of the input signal as the leakage current in response to the providing of the bias signal to the semiconductor region.

These and other features and advantages of the present invention will be understood upon consideration of the following detailed description of the invention and the accompanying drawings.

BRIEF DESCRIPTION OF THE DRAWINGS

Figure 1 illustrates and exemplary layout of an integrated circuit in which leakage current control circuits in accordance with the present invention can be used to selectively control leakage currents within a CMOS circuit.

Figure 2 is a functional schematic diagram of an NMOS leakage current control circuit in accordance with one embodiment of the present invention.

Figure 3 is a functional schematic diagram of an PMOS leakage current control circuit in accordance with another embodiment of the present invention.

Figure 4 is a schematic diagram of an exemplary operational amplifier for use in the circuits of Figures 2, 3, 5 and 7-10.

Figure 5 is a schematic diagram of the band gap voltage reference of Figure 3.

Figure 6 is a graph of bandgap reference voltage versus temperature for the band gap voltage reference circuit of Figure 5.

Figure 7 is a schematic diagram of a low current regulator for use as the current reference of Figure 3.

Figure 8 is a schematic diagram of a high current regulator for use as the current reference of Figure 3.

Figure 9 is a schematic diagram of the low pass current-to-voltage converter of Figure 3.

Figure 10 is a more detailed schematic diagram of the NMOS leakage current control circuit of Figure 2.

Figure 11 is a functional schematic diagram of a test chip for integrating and testing together in an integrated circuit the NMOS and PMOS leakage current control circuits of Figure 2 and 3.

DETAILED DESCRIPTION OF THE INVENTION

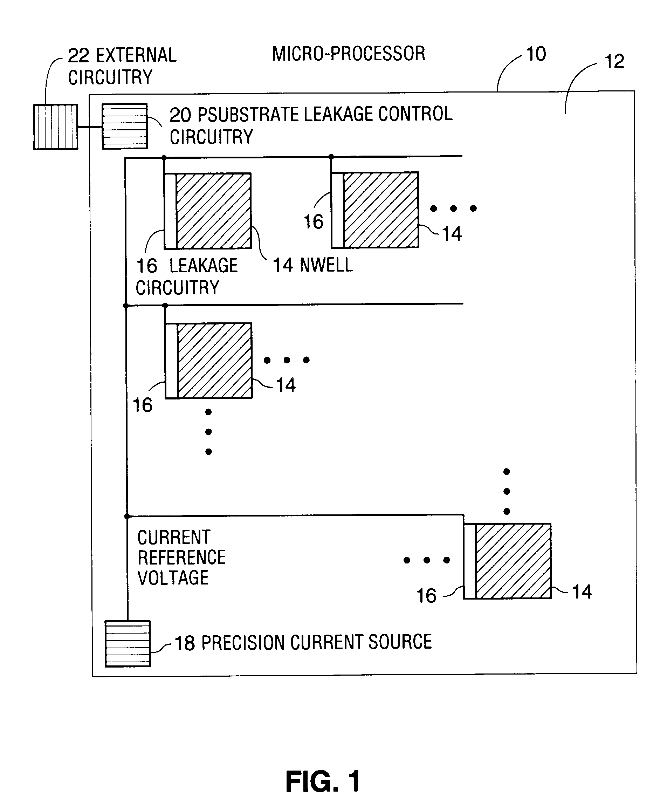

Referring to Figure 1, an integrated circuit chip 10 (e.g. a micro processor) with leakage current control circuits in accordance with the present invention include a P substrate 12 and one or more N wells 14. Integrated within each N well 14 is an N well leakage current control circuit 16, each of which is biased by a precision current source 18. Integrated within the P substrate is a P substrate current leakage control circuit 20 which, as discussed further below, is biased by some external circuitry 22. Each of the leakage current control circuits 14, 20 uses the "body effect" to adjust the threshold voltages of the PMOS and NMOS devices within their respective N wells and P substrate. Further, such circuits 14, 20 are designed to minimize both temperature and chip-to-chip variations. According to one embodiment of the present invention, the chip 10 uses an N well CMOS process with two separate threshold implants for both NMOS and PMOS devices, thereby allowing high threshold devices for memory and analog circuits and low threshold devices for high speed digital circuits. Such an N well CMOS process possesses the parameters shown below in Table 1, while the system level design specifications are shown below in Table 2.

TABLE 1

| N well CMOS Process Parameters | |
|---|---|
| Parameter | Value |
| N well Doping | $1 \times 10^{16}$ per centimeter$^3$ |
| Substrate Doping | $5 \times 10^{15}$ per centimeter$^3$ |
| NMOS Thresholds | 0V and 0.3V |
| PMOS Thresholds | 0V and -0.3V |
| NMOS $\gamma$ - Body Effect | 0.2 |
| PMOS $\gamma$ - Body Effect | 0.2 |
| NMOS $\lambda$ - Channel Length Modulation at L=0.5$\mu$m | 1/20 |
| PMOS $\lambda$ - Channel Length Modulation at L=0.5$\mu$m | 1/20 |
| NMOS $\kappa$ | 1 |
| PMOS $\kappa$ | 1 |
| N well Resistance | 900$\Omega$ per square |
| $t_{ox}$ | $100 \times 10^{-10}$ meters |
| NMOS mobility | 0.0638 meters per second$^2$ |
| PMOS mobility | 0.0199 meters per second$^2$ |
| NMOS Velocity Saturation | $7.48 \times 10^4$ meters per second |
| PMOS Velocity Saturation | $6.22 \times 10^4$ meters per second |
| N-diffusion Area Capacitance | $190 \times 10^{-6}$ F per meter$^2$ |
| N diffusion Side Wall Capacitance | $214 \times 10^{-12}$ F per meter |
| P diffusion Area Capacitance | $217 \times 10^{-6}$ F per meter$^2$ |
| P diffusion Side Wall Capacitance | $244 \times 10^{-12}$ F per meter |

TABLE 2

| System Level Design Specifications | |
|---|---|
| Specification | Value |
| Maximum Temperature | 67°C |
| Minimum Temperature | -150°C |
| Maximum Leakage Current | 10 $\mu$A |
| Minimum Leakage Current | 1 nA |
| Maximum Leakage Current Variation | 10% of DC Value |
| Maximum Leakage Current Ripple (RMS) | 10% of DC Value |
| Maximum Impact Ionization Current for Entire Chip | 1 mA |
| Maximum Power Supply Variation | 2% |

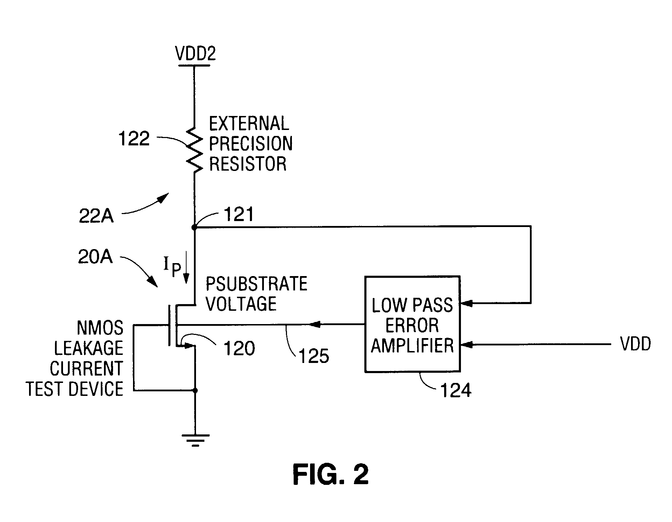

Referring to Figure 2, an NMOS leakage current control circuit 20a (for the P substrate) in accordance with one embodiment of the present invention includes an NMOS leakage current test device 120 and a low pass error amplifier 124, interconnected as shown. The associated external circuitry 22a includes an external precision resistor 122 connected between a positive voltage source VDD2 (where VDD2>VDD) and the node 121 at the drain of the NMOS leakage current test device 121. The desired leakage current $I_P$ through the test device 120 is controlled by selecting the external resistor 122 such that the voltage at node 121 is equal to VDD. This is accomplished by comparing the voltage at node 121 with VDD with the error amplifier 124 which outputs a substrate biasing voltage 125 to the P substrate, thereby establishing the threshold voltage $V_t$ for the test device 120 along with the other NMOS devices within the P substrate 12 (Figure 1).

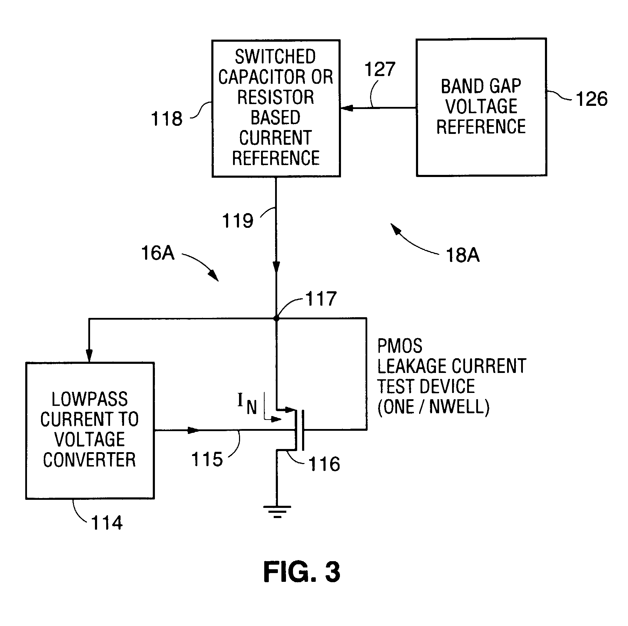

Referring to Figure 3, a PMOS leakage current control circuit 16a (for each N well 14) and precision current source 18a in accordance with another embodiment of the present invention includes a PMOS leakage current test device 116 (one per N well 14), a low pass current-to-voltage convertor 114, a current reference 118 and a voltage reference 126, interconnected as shown. The leakage current $I_N$ through the test device 116 is controlled by the convertor 114 which compares the voltage at the node 117 (connected to the source terminal of the test device 116) with a reference (discussed further below). Based upon such comparison, the converter 114 applies a biasing voltage 115 to the bulk of the N well, thereby establishing the threshold voltage $V_t$ for the test device 116 along with the other PMOS devices integrated within that same N well 14. The voltage at node 117 is established by a signal 119 generated by the current reference 118 which, in turn, uses a reference voltage 127 provided by the voltage reference 126.

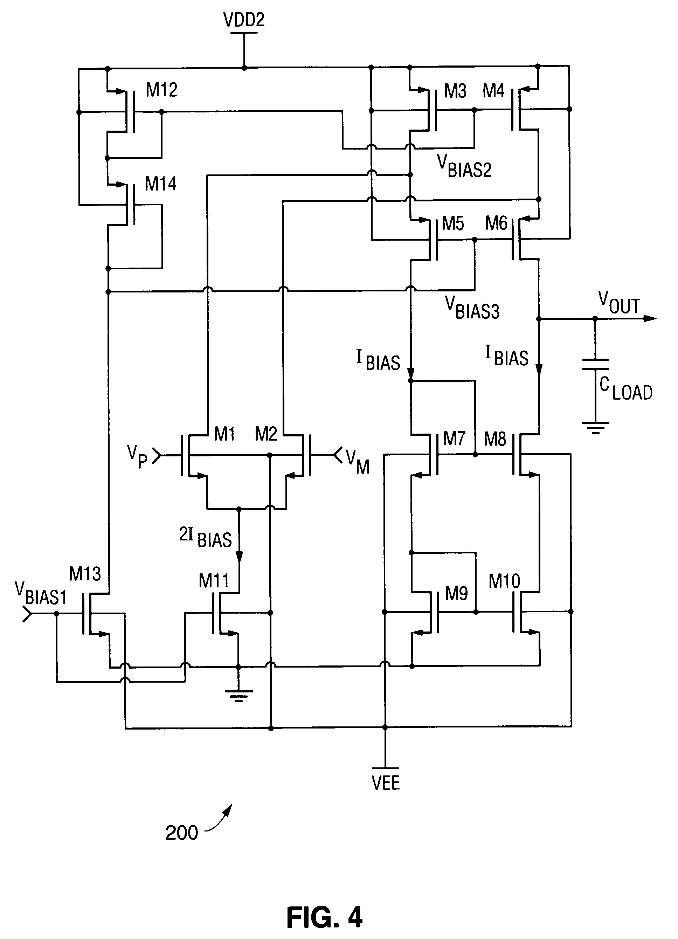

Referring to Figure 4, a folded cascode transconductance operational amplifier (op-amp) 200 useful in leakage current control circuits in accordance with the present invention includes NMOS devices M1, M2, M7-M11, M13 and PMOS devices M3-M6, M12, M14 and load capacitor $C_{load}$, interconnected as shown, biased between VDD2 and VEE (where VEE<VSS). One design of such op-amp, according to the parameters identified below in Table 3, achieves a DC gain of $1.2 \times 10^6$, a gain bandwidth of 189 KHz, a phase margin of 89° and a power dissipation of 18 mW. A second design, with the parameters identified below in Table 4, achieves a DC gain of $2.4 \times 10^9$, a gain bandwidth of 0.96 KHz, a phase margin of 90° and a power dissipation of 9 nW.

TABLE 3

| OP-AMP Design 1 | |
|---|---|
| M1 | $\frac{W}{L} = \frac{4\mu m}{4\mu m}$, High $V_t$ |
| M2 | $\frac{W}{L} = \frac{4\mu m}{4\mu m}$, High $V_t$ |
| M3 | $\frac{W}{L} = \frac{4\mu m}{2\mu m}$, High $V_t$ |
| M4 | $\frac{W}{L} = \frac{4\mu m}{2\mu m}$, High $V_t$ |
| M5 | $\frac{W}{L} = \frac{4\mu m}{2\mu m}$, Low $V_t$ |
| M6 | $\frac{W}{L} = \frac{4\mu m}{2\mu m}$, Low $V_t$ |
| M7 | $\frac{W}{L} = \frac{4\mu m}{4\mu m}$, High $V_t$ |
| M8 | $\frac{W}{L} = \frac{4\mu m}{4\mu m}$, High $V_t$ |
| M9 | $\frac{W}{L} = \frac{4\mu m}{4\mu m}$, High $V_t$ |
| M10 | $\frac{W}{L} = \frac{4\mu m}{4\mu m}$, High $V_t$ |
| M11 | $\frac{W}{L} = \frac{6\mu m}{0.5\mu m}$, Low $V_t$ |
| M12 | $\frac{W}{L} = \frac{4\mu m}{2\mu m}$, High $V_t$ |
| M13 | $\frac{W}{L} = \frac{6\mu m}{0.5\mu m}$, Low $V_t$ |
| M14 | $\frac{W}{L} = \frac{4\mu m}{2\mu m}$, High $V_t$ |
| $I_{bias}$ | 1 μA |
| $C_{load}$ | 16 pF |

TABLE 4

| OP-AMP Design 2 | |
|---|---|
| M1 | $\frac{W}{L} = \frac{4\mu m}{4\mu m}$, High $V_t$ |
| M2 | $\frac{W}{L} = \frac{4\mu m}{4\mu m}$, High $V_t$ |
| M3 | $\frac{W}{L} = \frac{4\mu m}{2\mu m}$, High $V_t$ |
| M4 | $\frac{W}{L} = \frac{4\mu m}{2\mu m}$, High $V_t$ |
| M5 | $\frac{W}{L} = \frac{4\mu m}{2\mu m}$, Low $V_t$ |
| M6 | $\frac{W}{L} = \frac{4\mu m}{2\mu m}$, Low $V_t$ |
| M7 | $\frac{W}{L} = \frac{4\mu m}{4\mu m}$, High $V_t$ |
| M8 | $\frac{W}{L} = \frac{4\mu m}{4\mu m}$, High $V_t$ |
| M9 | $\frac{W}{L} = \frac{4\mu m}{4\mu m}$, High $V_t$ |
| M10 | $\frac{W}{L} = \frac{4\mu m}{4\mu m}$, High $V_t$ |
| M11 | $\frac{W}{L} = \frac{4\mu m}{4\mu m}$, High $V_t$ |
| M12 | $\frac{W}{L} = \frac{4\mu m}{2\mu m}$, High $V_t$ |
| M13 | $\frac{W}{L} = \frac{4\mu m}{4\mu m}$, High $V_t$ |
| M14 | $\frac{W}{L} = \frac{4\mu m}{2\mu m}$, High $V_t$ |
| $I_{bias}$ | 1 nA |
| $C_{load}$ | 100 pF |

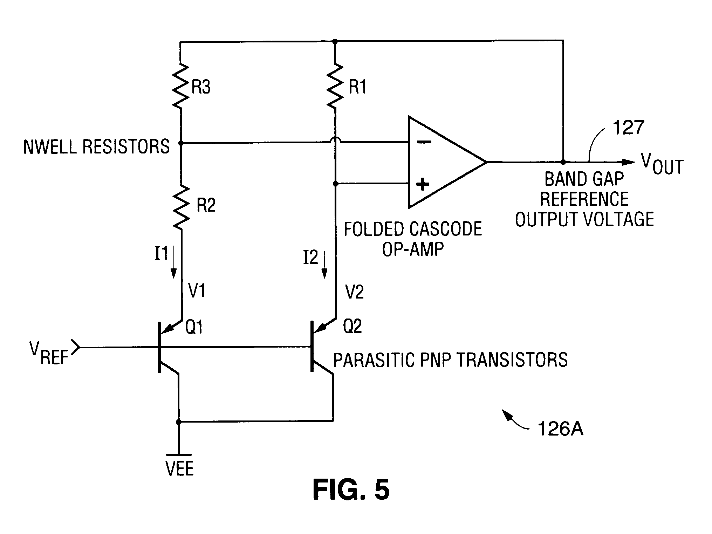

Referring to Figure 5, one embodiment 126a of the voltage reference 126 of Figure 3 is a band gap voltage reference used to produce a temperature-stabilized DC voltage 127. The two voltage references used by the band gap reference are two vertical parasitic PNP bipolar junction transistors (BJTs) Q1, Q2 formed by defusing a p+ region into an N well, thereby forming a PNP BJT with the substrate acting as the collector, the N well acting as the base and the p+ diffusion acting as the emitter. Resistors R1, R2 and R3 are formed using N wells. In accordance with well known band gap reference voltage design techniques, the band gap reference output voltage 127 will typically be within the range of 1.1-1.3 volts, i.e. approximately the band gap potential of silicon. By designing the band gap reference properly, i.e. adjusting the resistors R1, R2 and R3, the temperature variation of the two voltage sources Q1, Q2 approximately cancel, thereby causing the voltage generated by the band gap reference to be approximately independent of temperature.

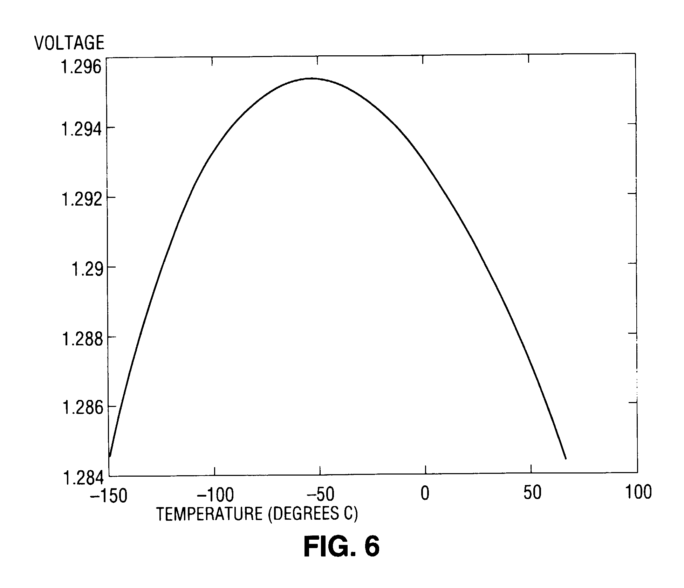

Referring to Figure 6, the band gap reference potential variation as a function of temperature as shown, with $V_{ref}$ set at zero volts, be realized.

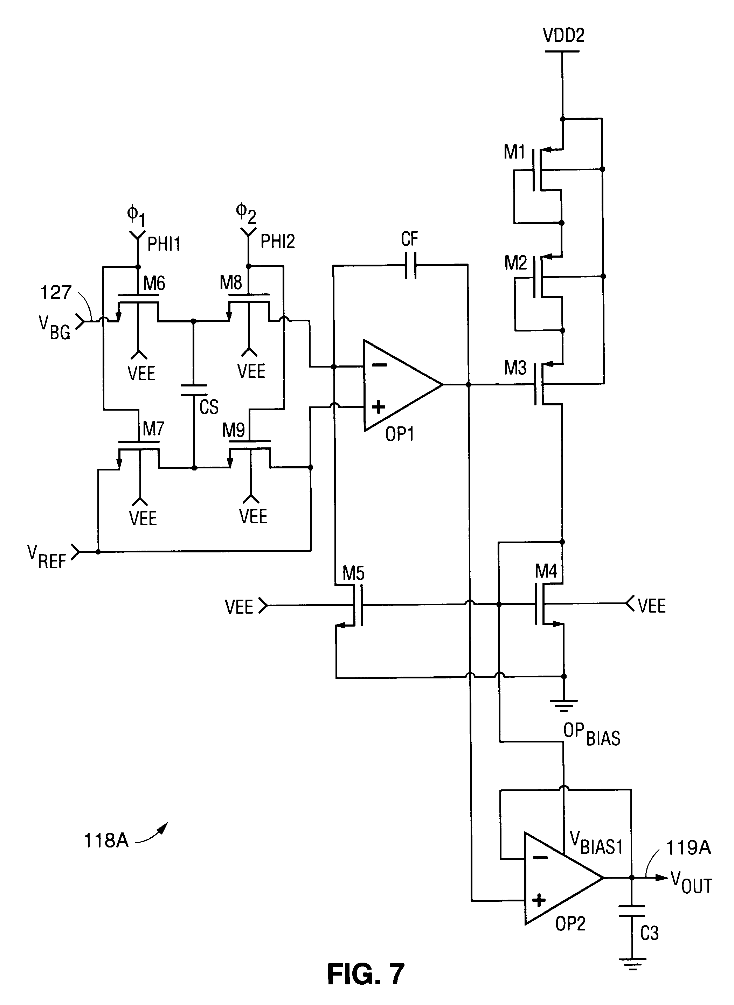

Referring to Figure 7, one embodiment of a current reference 118a for use as the current reference 118 in the circuit of Figure 3 is intended for low current applications, i.e. currents in the range of 1-200 nA. In this circuit 118a, the band gap reference voltage $V_{bg}$ 127 and reference voltage $V_{ref}$ are switched and applied across a switching capacitor $C_s$ in accordance with the inverse phases $\phi_1$ and $\phi_2$ of the chip system clock. In accordance with the second clock phase $\phi_2$, a differential voltage is applied between the inverting and non-inverting terminals of the first op-amp OP1, thereby producing a voltage across the feedback capacitor $C_F$. The output voltage of the op-amp OP1 is applied to the gate of MOSFET M3, which is totem-pole-coupled with diode-connected MOSFETs M1, M2 and M4, and to the non-inverting input of the second op-amp OP2. (The current mirror formed by MOSFETs M4 and M5 provide a biased voltage to the second op-amp OP2). The second op-amp OP2 is connected as a voltage follower, so the input voltage at its non-inverting input is buffered and provided as the output reference voltage 119a across a filter capacitor $C_3$.

One embodiment of the current reference of 118a of Figure 7 is designed according to the parameters identified below in Table 5. Such a design achieves a loop bandwidth of 1.5 KHz and a phase margin of 89°, and has a maximum current ripple of less than 0.1 percent.

TABLE 5

| Precision Low Current Regulator Design | |
|---|---|
| M1 | $\frac{W}{L} = \frac{2\mu m}{16\mu m}$, High $V_t$ |
| M2 | $\frac{W}{L} = \frac{2\mu m}{16\mu m}$, High $V_t$ |
| M3 | $\frac{W}{L} = \frac{2\mu m}{16\mu m}$, High $V_t$ |
| M4 | $\frac{W}{L} = \frac{4\mu m}{4\mu m}$, High $V_t$ |
| M5 | $\frac{W}{L} = \frac{4\mu m}{4\mu m}$, High $V_t$ |
| M6 | $\frac{W}{L} = \frac{1\mu m}{0.5\mu m}$, Low $V_t$ |
| M7 | $\frac{W}{L} = \frac{1\mu m}{0.5\mu m}$, Low $V_t$ |
| M8 | $\frac{W}{L} = \frac{1\mu m}{0.5\mu m}$, Low $V_t$ |
| M9 | $\frac{W}{L} = \frac{1\mu m}{0.5\mu m}$, Low $V_t$ |
| $I_{reg}$ | 1.3 nA |
| CS | 1 pF |
| CF | 16 pf |
| $f_{clock}$ | 1 KHz |
| OP1 | OP-AMP design 1 |
| OP2 | OP-AMP design 2 |

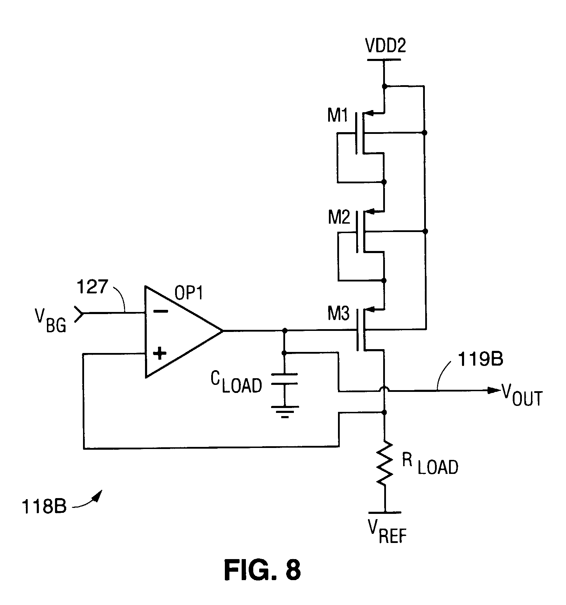

Referring to Figure 8, another embodiment of a current reference 118b for use as the current reference 118 in the circuit of Figure 3 is intended for high current applications, i.e. currents between 200 nA and 10 μA. In this circuit 118b, the band gap voltage reference 127 is applied to the inverting input of an op-amp OP1 whose output provides the output 119b of the current reference and drives the gate of MOSFET M3, which is totem-pole-coupled with diode-connected MOSFETs M1 and M2 and an external load resistor $R_{load}$ biased between VDD2 and $V_{ref}$. The voltage between the drain of MOSFET M3 and the external resistor $R_{load}$ is fed back to the non-inverting input. One embodiment of this circuit 118b is designed in accordance with the parameters identified below in Table 6. Such a design achieves a loop bandwidth of 400 Hz, a phase margin of 80° and a DC loop gain of $1.24 \times 10^7$.

TABLE 6

| Precision High Current Regulator Design | |
|---|---|
| M1 | $\frac{W}{L} = \frac{4\mu m}{4\mu m}$, High $V_t$ |
| M2 | $\frac{W}{L} = \frac{4\mu m}{4\mu m}$, High $V_t$ |
| M3 | $\frac{W}{L} = \frac{4\mu m}{4\mu m}$, High $V_t$ |
| $R_{load}$ | 1.3 MΩ, 1% |
| $I_{reg}$ | 1 μA |
| $C_p$ | 10 pF |
| $C_{load}$ | 10,000 pf Silver Mica |
| OP1 | OP-AMP Design 1 |

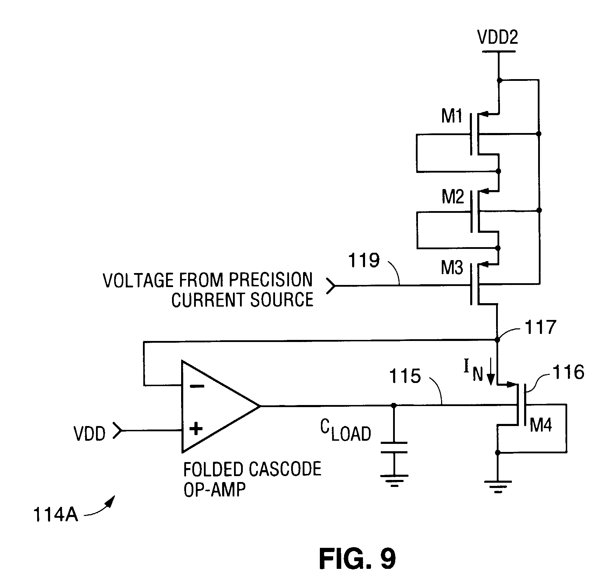

Referring to Figure 9, one embodiment 114a of the convertor 114 in the circuit of Figure 3 includes an op-amp and MOSFETs, interconnected as shown. The PMOS test device 116 receives its leakage current via totem-pole-coupled MOSFETs M1, M2, M3 biased between VDD2 and circuit ground, and controlled by the voltage 119 (from the current reference 118). The voltage at node 117 is compared by the op-amp to VDD, with the resulting output voltage 115 applied as the N well bias. One embodiment of this circuit 114a is designed according to the parameters identified below in Table 7. Such a design achieves a loop bandwidth of 25 KHz, a phase margin of 82° and a DC loop gain of $1.2 \times 10^6$.

TABLE 7

| PMOS Leakage Current Regulator 1 | |
| --- | --- |
| M1 | $\frac{W}{L} = \frac{2\mu m}{16\mu m}$, High $V_t$ |
| M2 | $\frac{W}{L} = \frac{2\mu m}{16\mu m}$, High $V_t$ |
| M3 | $\frac{W}{L} = \frac{2\mu m}{16\mu m}$, High $V_t$ |
| M4 | $\frac{W}{L} = \frac{10\mu m}{0.5\mu m}$, High $V_t$ |
| $I_{reg}$ | 1 nA |
| $C_{load}$ | 16 pf |
| OP1 | OP-AMP Design 1 |

An alternative design for this circuit 114a is in accordance with the parameters identified below in Table 8. Such a design achieves a loop bandwidth of 25 KHz, a phase margin of 89° and DC loop gain of $1.18 \times 10^6$.

TABLE 8

| PMOS Leakage Current Regulator 2 | |
| --- | --- |
| M1 | $\frac{W}{L} = \frac{2\mu m}{16\mu m}$, High $V_t$ |
| M2 | $\frac{W}{L} = \frac{2\mu m}{16\mu m}$, High $V_t$ |
| M3 | $\frac{W}{L} = \frac{2\mu m}{16\mu m}$, High $V_t$ |
| M4 | $\frac{W}{L} = \frac{10\mu m}{0.5\mu m}$, Low $V_t$ |
| $I_{reg}$ | 1 μA |
| $C_{load}$ | 16 pf |
| OP1 | OP-AMP Design 1 |

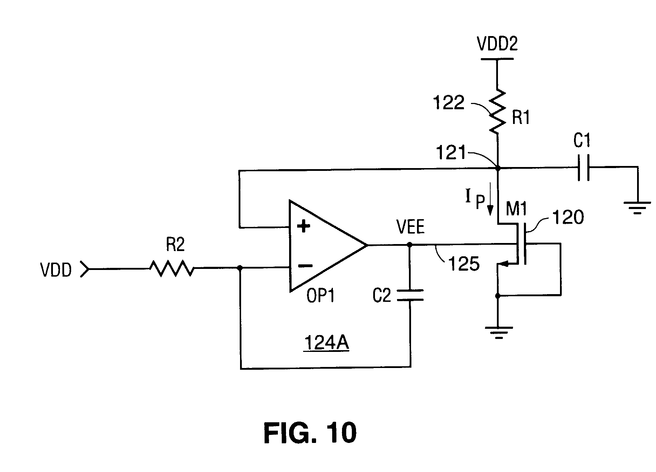

Referring to Figure 10, one embodiment of the leakage current control circuit 20a of Figure 2 includes an error amplifier 124a with an op-amp OP1, feedback capacitor C2 and input resistor R2, interconnected as shown. The op-amp OP1 is biased between +3 and -3 volts, and capacitor $C_1$ is the parasitic pad capacitance of node 121. One embodiment of this circuit is designed in accordance with the parameters identified below in Table 9. Such a design achieves a loop bandwidth of 1 KHz, a phase margin of 89° and a DC open loop gain of $1.0 \times 10^6$.

TABLE 9

| NMOS Leakage Regulator | |
| --- | --- |
| M1 | $\frac{W}{L} = \frac{3\mu m}{0.5\mu m}$, Low $V_t$ |
| $R_1$ | 2 MΩ, 1% |
| $C_1$ | 100 pF Silver Mica |
| $R_2$ | 20 KΩ, 1% |
| $C_2$ | 10,000 pF Silver Mica |
| $I_{reg}$ | 1 μA |
| OP1 | TL071P |

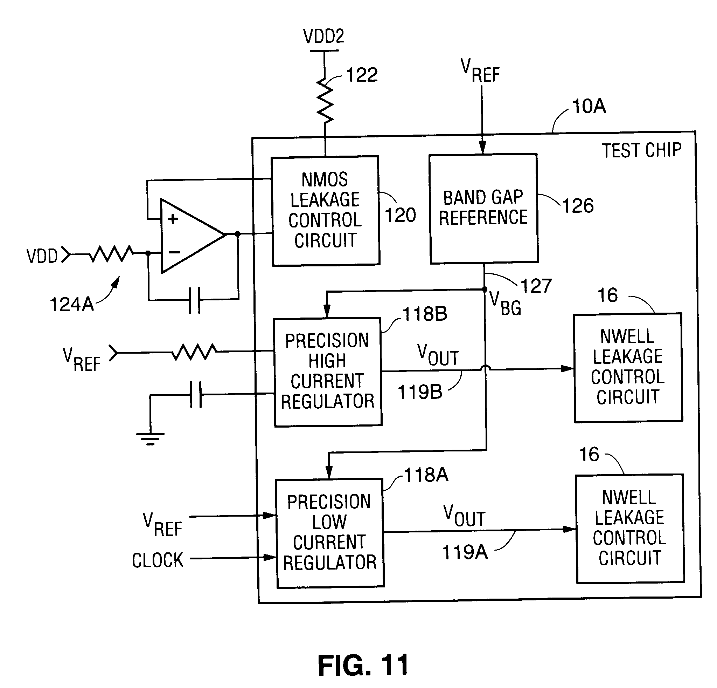

Referring to Figure 11, a test chip 10a for implementing and testing the leakage current control circuits discussed above can be configured as shown. Such a chip 10a would also contain various digital circuits so as to simulate a real operational environment. In accordance with the foregoing discussion, this test chip 10a would require an external op-amp, two external capacitors and three external one-percent resistors. Also required would be 3 power supply voltages:

VDD=1 volt; VDD2=3 volts; and VSS2=-3 volts (for the op-amp).

Various other modifications and alterations in the structure and method of operation of this invention will be apparent to those skilled in the art without departing from the scope and spirit of the invention. Although the invention has been described in connection with specific preferred embodiments, it should be understood that the invention as claimed should not be unduly limited to such specific embodiments. It is intended that the following claims define the scope of the present invention and that structures and methods within the scope of these claims and their equivalents be covered thereby.

## Claims

1. An apparatus including a leakage current control circuit, the leakage current control circuit comprising:

    a semiconductor region;
    a signal node for conducting an input signal;
    a semiconductor device which is integrated within the semiconductor region and coupled to the signal node for conducting a leakage current; and
    a bias circuit, coupled to the signal node and the semiconductor region, for receiving a portion of the input signal and in response thereto providing a bias signal to the semiconductor region, wherein the semiconductor device receives and selectively conducts another portion of the input signal as the leakage current in response to the providing of the bias signal to the semiconductor region.

2. The apparatus of Claim 1, wherein the semiconductor region comprises an integrated circuit substrate and the semiconductor device comprises a MOS transistor.

3. The apparatus of Claim 1, wherein the semiconductor region comprises a semiconductor well within an integrated circuit substrate and the semiconductor device comprises a MOS transistor.

4. The apparatus of Claim 1, wherein the bias circuit is further for receiving a reference signal to which the leakage current corresponds and providing the bias signal to the semiconductor region in response to the reference signal and the portion of the input signal.

5. The apparatus of Claim 1, further comprising a signal source, coupled to the signal node, for providing the input signal thereto.

6. The apparatus of Claim 1, further comprising an integrated circuit into which the leakage current control circuit is integrated.

7. The apparatus of Claim 1, further comprising a computer into which the leakage current control circuit is incorporated.

8. A method of providing an apparatus including a leakage current control circuit, the method comprising the steps of:

    providing a semiconductor region;
    providing a signal node for conducting an input signal;
    providing a semiconductor device which is integrated within the semiconductor region and coupled to the signal node for conducting a leakage current; and
    providing a bias circuit, coupled to the signal node and the semiconductor region, for receiving a portion of the input signal and in response thereto providing a bias signal to the semiconductor region, wherein the semiconductor device receives and selectively conducts another portion of the input signal as the leakage current in response to the providing of the bias signal to the semiconductor region.

9. The method of Claim 8, wherein the step of providing a semiconductor region comprises providing an integrated circuit substrate and the step of providing a semiconductor device comprises providing a MOS transistor.

10. The method of Claim 8, wherein the step of providing a semiconductor region comprises providing a semiconductor well within an integrated circuit substrate and the step of providing a semiconductor device comprises providing a MOS transistor.

11. The method of Claim 8, wherein the bias circuit is further for receiving a reference signal to which the leakage current corresponds and providing the bias signal to the semiconductor region in response to the reference signal and the portion of the input signal.

12. The method of Claim 8, further comprising the step of providing a signal source, coupled to the signal node, for providing the input signal thereto.

13. The method of Claim 8, further comprising the step of providing an integrated circuit into which the leakage current control circuit is integrated.

14. The method of Claim 8, further comprising the step of providing a computer into which the leakage current control circuit is incorporated.

15. A method of controlling leakage current within an integrated circuit, comprising the steps of:

   receiving an input signal;
   providing a bias signal to a semiconductor region in response to a portion of the input signal; and
   conducting another portion of the input signal as a leakage current with a semiconductor device which is integrated within the semiconductor region in response to the providing of the bias signal to the semiconductor region.

16. The method of Claim 15, wherein the step of providing a bias signal to a semiconductor region comprises providing the bias signal to an integrated circuit substrate, and wherein the step of conducting another portion of the input signal as a leakage current with a semiconductor device comprises conducting the another portion of the input signal as a leakage current with a MOS transistor.

17. The method of Claim 15, wherein the step of providing a bias signal to a semiconductor region comprises providing the bias signal to a semiconductor well within an integrated circuit substrate, and wherein the step of conducting another portion of the input signal as a leakage current with a semiconductor device comprises conducting the another portion of the input signal as a leakage current with a MOS transistor.

18. The method of Claim 15, further comprising the step of receiving a reference signal to which the leakage current corresponds, wherein the step of providing a bias signal to a semiconductor region comprises providing the bias signal to the semiconductor region in response to the reference signal and the portion of the input signal.

19. The method of Claim 15, further comprising the step of performing the recited steps within an integrated circuit.

20. The method of Claim 15, further comprising the step of performing the recited steps within a computer.

MICRO-PROCESSOR

22 EXTERNAL CIRCUITRY

10

12

20 PSUBSTRATE LEAKAGE CONTROL CIRCUITRY

16

14

16  LEAKAGE CIRCUITRY

14 NWELL

16

14

CURRENT REFERENCE VOLTAGE

16

14

18 PRECISION CURRENT SOURCE

**FIG. 1**

VDD2

122 —/\/\/\— EXTERNAL PRECISION RESISTOR

22A ↗ 121

20A ↘ $I_P$ ↓

PSUBSTRATE VOLTAGE

NMOS LEAKAGE CURRENT TEST DEVICE

120

125

LOW PASS ERROR AMPLIFIER

VDD

124

## FIG. 2

**FIG. 3**

**FIG. 4**

NWELL RESISTORS

R3

R1

127

$V_{OUT}$

BAND GAP
REFERENCE
OUTPUT VOLTAGE

FOLDED CASCODE
OP-AMP

R2

I1

V1

Q1

$V_{REF}$

I2

V2

Q2

PARASITIC PNP TRANSISTORS

126A

VEE

**FIG. 5**

**FIG. 6**

**FIG. 7**

**FIG. 8**

**FIG. 9**

**FIG. 10**

VDD2

$\rightharpoondown$ 122

$V_{REF}$

10A

TEST CHIP

NMOS LEAKAGE CONTROL CIRCUIT — 120

BAND GAP REFERENCE — 126

VDD $\rightarrow$

$-124A$

$V_{REF} \rightarrow$

PRECISION HIGH CURRENT REGULATOR — 118B

$V_{OUT}$

127

$V_{BG}$

16

NWELL LEAKAGE CONTROL CIRCUIT

119B

$V_{REF} \rightarrow$

CLOCK $\rightarrow$

PRECISION LOW CURRENT REGULATOR — 118A

$V_{OUT}$

119A

16

NWELL LEAKAGE CONTROL CIRCUIT

# FIG. 11

European Patent
Office

**EUROPEAN SEARCH REPORT**

Application Number

EP 96 63 0062

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP 0 386 804 A (N.V. PHILIPS' GLOEILAMPENFABRIEKEN) <br> * abstract; claims 1-5; figures 1A,2,3 * <br> --- | 1-7 | G01R31/28 <br> G06F11/24 |
| P,A | EP 0 699 998 A (OKI ELECTRIC INDUSTRY CO.) <br> * abstract; claims 1-6; figures 1,3 * <br> ----- | 1-7 | |

TECHNICAL FIELDS
SEARCHED (Int.Cl.6)

G06F

The present search report has been drawn up for all claims

| Place of search | Date of completion of the search | Examiner |
|---|---|---|
| THE HAGUE | 7 March 1997 | Sarasua Garcia, L |